# EUROPÄISCHE PATENTANMELDUNG

(11) **EP 4 752 259 A1**
(43) Veröffentlichungstag der Anmeldung: **03.06.2026**
(21) Anmeldenummer: 25218224.1
(22) Anmeldetag: 25.11.2025
(51) Int. Cl.: C23C 28/00, C23C 14/02, C23C 14/06, C23C 30/00, F16J 1/02, F16C 33/12, F16J 9/26

(54) **BESCHICHTETE KOLBENSTANGE UND VERFAHREN ZU IHRER HERSTELLUNG**

(30) Priorität: 29.11.2024 DE 102024003985
(71) Anmelder: Hydrosaar GmbH, 66280 Sulzbach (DE)
(72) Erfinder: Schäfer, Björn Christian, 66450 Bexbach (DE); Fery, Jens-Holger, 66806 Ensdorf (DE); Stalter, Klaus, 66386 St. Ingbert (DE)
(74) Vertreter: Bartels und Partner, Patentanwälte

(57) **Zusammenfassung**

2. Kolbenstange (22) für einen hydraulischen Arbeitszylinder (8), die zumindest auf ihrer Oberseite (56) einen Stahlwerkstoff aufweist, der zumindest teilweise mit einer Lage (62) überzogen ist, die Nickel oder Nickelbestandteile in Form eines galvanisch aufgebrachten Überzugs aufweist, der als weitere Lage (64) darüberliegend zumindest teilweise eine DLC-Beschichtung aufweist, die mittels eines physikalischen Gasphasenabscheideverfahrens aufgebracht ist.

## Beschreibung

Die Erfindung betrifft eine Kolbenstange für einen hydraulischen Arbeitszylinder, bestehend aus einem Stahlwerkstoff, der mit einer Beschichtung versehen ist. Die Erfindung betrifft des Weiteren ein Verfahren zum Auftragen einer solchen Beschichtung auf Kolbenstangen für hydraulische Arbeitszylinder.

Durch EP 0 391 294 B1 ist eine Beschichtung von Kolbenstangen hydraulischer Arbeitszylinder bekannt, wobei auf die Kolbenstangen aus Kohlenstoffstahl eine metallische Haftschicht aus Nickel und Chrom und auf diese eine keramische Schicht aus Aluminiumoxid (*Al*₂*O*₃) mit einem Anteil von mindestens 10% Titandioxid (Ti*O*₂) aufgebracht ist. Bei der bekannten Beschichtung beträgt die Schichtdicke der keramischen Schicht 100 *µ*m bis 300 *µ*m und die Schichtdicke der darunterliegenden metallischen Haftschicht beträgt mindestens 10 *µ*m bis 70 *µ*m.

Bei Kolbenstangen hydraulischer Arbeitszylinder, die auch im Offshore-Bereich und an Bord von Schiffen eingesetzt sind, verursacht die aggressive Umgebung, die regelmäßig salzhaltig ist, Korrosion und Verschleiß und verkürzt insoweit wesentlich die Lebensdauer dahingehender Bauteile. Hieraus ergibt sich zwingend das Vorsehen eines Korrosionsschutzes für alle Bauteile, die bewegungsfähig bleiben sollen und die aus normalem Stahl, regelmäßig in Form von Kohlenstoffstahl, hergestellt sind. Das genannte Patentdokument führt weiter aus, dass üblicherweise solche Bauteile, wie Kolbenstangen, mit einer metallischen Schicht aus Chrom und/oder Nickel versehen sind, wobei diese metallische Schicht erfahrungsgemäß wiederum gegen chemische Einflüsse anfällig ist, die zum sogenannten Lochfraß führen, bei dem die Chromschicht von außen her angefressen und dabei zerstört wird, wodurch das Bauteil selbst nach einiger Zeit unbrauchbar wird. Bauteile aus sogenanntem Niro-Stahl sind zur Verschleißminderung gleichfalls mit einer Chromschicht versehen und insgesamt sehr teuer in der Anschaffung.

Eine keramische Beschichtung hingegen besitzt einen auffällig großen Widerstand gegen eine mögliche chemische Beschädigung und weist auch eine sehr hohe Verschleißfestigkeit bei mechanischen Einflüssen auf, die sich insbesondere durch Staub, Schmutz, Sand, Salz und dergleichen mehr ergeben. Die Auswahl der Werkstoffe für die keramische Beschichtung ist derart getroffen, dass jedenfalls der Verschleiß am jeweiligen Lager, zum Beispiel an einer Zylinderführung einer Kolbenstange, nicht unzulässig hoch wird. Demgemäß ist die keramische Beschichtung derart aufgebaut, dass sie Korrosionsbeständigkeit und Härte in einer Weise miteinander vereint, dass die Lebensdauer einen möglichst hohen Wert erreicht.

Nachteilig ist, dass solche keramischen Schichten von Natur aus grundsätzlich porös sind. Zwar kann die Porosität im Herstellungsprozess in einem gewissen Bereich eingestellt respektive niedrig vorgegeben werden, lässt sich aber dem Grunde nach nie ganz vermeiden. Dies hat in der Praxis zur Folge, dass es zu einer Leckage durch die Poren der Keramikbeschichtung nach außen kommen kann, insbesondere, wenn eine mit Keramik beschichtete Kolbenstange dem üblichen Fluiddruck im Zylinderinnenraum eines Arbeitszylinders ausgesetzt ist, in welchem die Kolbenstange längsverfahrbar geführt ist. Dergestalt ist ein Ausfall des hydraulischen Arbeitszylinders sowie vergleichbar beschichteter Bauteile vorprogrammiert.

Ausgehend von diesem Stand der Technik liegt demgemäß der Erfindung die Aufgabe zugrunde, eine Kolbenstange für hydraulische Arbeitszylinder zu schaffen, die mit einer Beschichtung versehen ist, die die beschriebenen Nachteile im Stand der Technik nicht aufweist.

Eine dahingehende Aufgabe löst eine Kolbenstange mit den Merkmalen des Patentanspruches 1.

Die erfindungsgemäße Kolbenstange für einen hydraulischen Arbeitszylinder weist zumindest auf ihrer Oberseite einen Stahlwerkstoff auf, der zumindest teilweise mit einer Lage überzogen ist, die Nickel oder Nickelbestandteile in Form eines galvanisch aufgebrachten Überzugs aufweist, der als weitere Lage darüberliegend zumindest teilweise eine DLC-Beschichtung aufweist, die mittels eines physikalischen Gasphasenabscheideverfahrens (PVD) aufgebracht ist. Dergestalt ist insgesamt eine Beschichtung gewählt, die vollständig keramikfrei gehalten und ausgesprochen chemikalienbeständig sowie nicht porös ist. Dahingehende Beschichtungslagen lassen sich in wirtschaftlicher Weise kostengünstig in großer Stückzahl sowie mit geringen Ausschussraten herstellen und aufgrund der fehlenden Porosität sind auch keine Leckagen zu erwarten, sofern derart beschichtete Kolbenstangen für hydraulische Arbeitszylinder entsprechend unter hohem Betriebsdruck stehend im Betrieb, auch unter Last, ein- und ausfahren.

Besonders bevorzugt beinhaltet die zuäußerst liegende DLC-Beschichtung gleichfalls Nickel, so dass sich insgesamt für die Beschichtung ein homogener Materialaufbau unter durchgehendem Einsatz von Nickel als Basiswerkstoff ergibt, bei gleichzeitig hoher Chemikalienbeständigkeit aller Lagen respektive Schichten unter Einbezug von Säuren, insbesondere in Form von Salzsäure in unterschiedlicher Konzentration oder in Form von Laugen.

Bei einer besonders bevorzugten Ausführungsform der erfindungsgemäßen Kolbenstange ist vorgesehen, dass die eine innere Lage zumindest aus einer der folgenden Materialien besteht:
- Nickel (Ni)
- Nickel/Molybdän (Ni/Mo)
- Nickel/Chrom (Ni/Cr)
- Chromcarbid (CrC/NiCr)
- Chromcarbid-Wolframcarbid (CrC/WC/NiCr)
- Nickel/Chrom/Silizium (Ni/Cr/Si)

Aufgrund der Nickelanteile für die innere Beschichtung hat sich dies als besonders geeignet für eine chemikalienbeständige Lage erwiesen, wobei Nickel grundsätzlich Stahlwerkstoffe korrosionsbeständig macht.

Bei einer weiteren bevorzugten Ausführungsform der erfindungsgemäßen Kolbenstange ist vorgesehen, dass die DLC-Beschichtung als der weiteren Lage, ausgehend von der einen Lage, in Hintereinanderanordnung folgenden Aufbau hat:
- eine Haftschicht aus Chrom,
- eine Zwischenschicht aus Chrom/Nickel, und
- eine Funktionsschicht in der Art a-C:H

Vorzugsweise ist dabei weiter vorgesehen, dass die weitere Lage als Funktionsschicht derart amorphen Kohlenstoff aufweist, dass die Kolbenstange schwarz gefärbt und glanzlos ist. Dies vorausgeschickt, versteht der Fachmann unter DLC (Diamond-like Carbon) eine Familie kohlenstoffbasierter Beschichtungen, die aufgrund ihrer Diamant-Kristallstruktur (Tetragonal) eine extreme Härte aufweisen und dabei gleichzeitig aufgrund ihrer Grafitkristallstruktur (hexagonal) weich und gleitfähig sind, was sie besonders geeignet macht für den Einsatz bei Kolbenstangen von hydraulischen Arbeitszylindern im skizzierten Rahmen.

Bei einer bevorzugten Ausführungsform der erfindungsgemäßen Kolbenstange ist dabei weiter vorgesehen, dass die eine Lage eine Schichtdicke zwischen 15 *µ*m bis 500 *µ*m, vorzugsweise zwischen 25 *µ*m bis 150 *µ*m, und die jeweils weitere Lage eine Schichtdicke zwischen 1 *µ*m bis 5 *µ*m, besonders bevorzugt zwischen 2 *µ*m bis 4 *µ*m, aufweist. Demgemäß kann die chemikalienbeständige Nickel-Lage, bestehend aus einer oder mehreren möglichen Schichten, entsprechend im Durchmesser dick ausgebildet sein gegenüber einer oder mehreren, sehr dünnen Schichten der jeweiligen außenliegenden DLC-Lage.

Bei einer weiteren bevorzugten Ausführungsform der erfindungsgemäßen Kolbenstange ist vorgesehen, dass der Stangenwerkstoff aus einem Kohlenstoffstahl besteht, wie 42CrMo4. Als Kohlenstoffstahl respektive Carbonstahl wird ein solcher Stahl bezeichnet, der neben seinem Hauptbestandteil Eisen als Nebenbestandteil hauptsächlich Kohlenstoff (C) enthält. Er wird insoweit auch einfach als C-Stahl bezeichnet. Dabei handelt es sich regelmäßig um einen härtbaren, schmiedbaren Stahl mit einem Kohlenstoffgehalt, regelmäßig von bis zu 2,1%. Dahingehender Kohlenstoffstahl ist zwar grundsätzlich nicht rostfrei, lässt sich aber entsprechend gut verarbeiten, in eine beliebige Form bringen und mit nickelhaltigen Beschichtungen im gewünschten Rahmen versehen. Alternativ besteht auch grundsätzlich die Möglichkeit, die Kolbenstange aus Edelstahl auszubilden.

Gegenstand der Erfindung ist auch ein Verfahren zum Herstellen der vorstehend vorgestellten Kolbenstange mit den Merkmalen des Patentanspruches 9 sowie die Verwendung eines hydraulischen Arbeitszylinders unter Einbezug einer solchen Kolbenstange für militärische Zwecke gemäß der Merkmalsausgestaltung des Patentanspruches 10.

Da eine nach außen hin mit DLC beschichtete Kolbenstange keinen Glanz aufweist und im Übrigen anthrazit, vorzugsweise völlig schwarz ist, ist im Einbauzustand im zugehörigen Arbeitszylinder im Betrieb desselben eine ausgefahrene Kolbenstange von außen nicht oder jedenfalls kaum zu erkennen, so dass ihr insoweit eine Tarnfunktion zukommt, was sie besonders geeignet macht für den Einsatz bei militärischen Fahrzeugen, beispielsweise im Rahmen des hydraulischen Aufständerns von Fahrzeugplattformen einschließlich damit ausgerüsteter Geschütze.

Im Folgenden wird die erfindungsgemäße Lösung anhand eines Ausführungsbeispiels nach der Zeichnung näher erläutert. Dabei zeigen in prinzipieller und nicht maßstäblicher Darstellung die
- Fig. 1: in der Art eines Längsschnittes einen Arbeitszylinder als Ganzes mit eingefahrener Kolbenstange; und
- Fig. 2: einen Beschichtungsaufbau in Form eines vergrößert herausgestellten Oberflächenausschnittes der Kolbenstange nach der Figur 1.

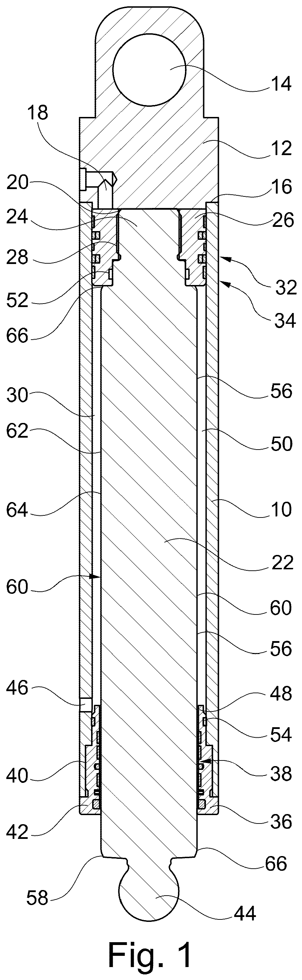

Der im Längsschnitt in Figur 1 dargestellte hydraulische Arbeitszylinder weist ein hohlzylindrisches Gehäuse 10 respektive Zylindergehäuse mit konstantem Außendurchmesser auf. In Blickrichtung auf die Figur 1 gesehen, ist das hohlzylindrische Gehäuse 10 nach oben hin von einem Kopfteil 12 hermetisch verschlossen, das endseitig ein Lagerauge 14 aufweist. Insbesondere kann das Kopfteil 12 im Bereich seines zylindrischen Inneneingriffs mit dem hohlzylindrischen Gehäuse 10 entlang einer Schweißnaht 16 verschweißt sein. Am linken Rand des Kolbenteiles 12 ist für eine Fluidführung ein gewinkelter Fluidkanal 18 vorhanden, der an seiner unteren freien Stirnseite in einen Fluid- oder Kolbenraum 20 ausmündet, dessen Volumen auf Null oder im Wesentlichen auf Null gestellt ist, im Hinblick auf die nach oben hin eingefahrene Kolbenstange 22, die sich insoweit in ihrer voll eingefahrenen Stellung befindet.

Die Kolbenstange 22 weist an ihrem oberen einen Ende und in Stufen abgesetzt ein Stangenteil 24 auf, das gegenüber dem freien Durchmesser der Kolbenstange 22 reduziert ist. Das Stangenteil 24 ist außenumfangsseitig mit einem Außengewinde versehen, das mit einem zugehörigen Innengewinde eines hohlzylindrischen Führungsteils 26 eine gemeinsame Gewindestrecke 28 ausbildet. Das Führungssteil 26 ist auf das obere freie Ende der Kolbenstange 22 aufgeschraubt und insoweit an dieser festgelegt. Des Weiteren ist das Führungsteil 26 außenumfangsseitig entlang einer Innenwand 30 des Gehäuses respektive Zylindergehäuses 10 längsverfahrbar geführt und weist hierfür in üblicher und daher nicht näher beschriebener Weise eine als Ganzes mit 32 bezeichnete Kolbendichtung mit Führungsbändern auf. Für die dahingehende Führung des Führungsteils 26, das als Kolben der insoweit gebildeten Kolben-Stangeneinheit 34 dient, ist die Innenwand 30 des Zylindergehäuses 10 im Durchmesser konstant ausgebildet und nach unten hin in Richtung des freien Endes des Gehäuses 10 von einem weiteren Führungsteil 36 im Wesentlichen dicht verschlossen.

Das dahingehend weitere Führungsteil 36 führt den Außenumfang der Kolbenstange 22 während der Ein- und Ausfahrbewegung der Kolben-Stangeneinheit 34 und weist insoweit in bekannter und daher nicht näher beschriebener Weise auf ihrer Innenumfangsseite ein als Ganzes mit 38 bezeichnetes Dicht- und Führungspaket auf, entlang dessen sich die verfahrbare Kolbenstange 22 in jeder Verfahrstellung entsprechend abstützt. Das dahingehende Dicht- und Führungspaket 38 als Teil des weiteren Führungsteiles 36 ist in das untere Ende des Gehäuses 10 entlang einer weiteren Gewindestrecke 40 entsprechend eingeschraubt. Auch das weitere Führungsteil 36 ist in abschnittsweisen Stufen in das untere Ende des Gehäuses 10 eingebracht und stützt sich mit einer verbreiterten Schulter 42 an der freien Stirnseite des Gehäuses 10 ab. Die Kolbenstange 22 weist des Weiteren an ihrem unteren freien Ende ein kugelförmiges Abschlussteil 44 auf, das wiederum im Durchmesser gegenüber dem Außendurchmesser der Kolbenstange 22 reduziert ist und das beispielhaft der Aufnahme eines nicht dargestellten Stütztellers dienen kann, mit welchem sich Fahrzeugplattformen (nicht dargestellt) auf einem Untergrund frei aufständern lassen, wobei das Lagerauge 14 insoweit mit der genannten Fahrzeugplattform gekoppelt ist. Andere Anwendungen des Arbeitszylinders nach der Figur 1 sind hier aber ohne Weiteres möglich; jedenfalls wird der fluidische Arbeitszylinder nach der Figur 1 nur im Bereich der Hydraulik, insbesondere der Ölhydraulik, eingesetzt.

Des Weiteren ist am unteren Ende des Zylindergehäuses 10 eine kanalartige Durchlassstelle 46 in der Art einer Bohrung eingebracht, die nach unten hin zumindest teilweise von einem ring- oder absatzartigen Vorsprung 48 des weiteren Führungsteiles 36 unter Einhalten eines radialen Abstandes in etwa hälftig überdeckt ist, so dass insoweit der Vorsprung 48 des weiteren Führungsteiles 36 dazu dient, die Anschlussbohrung offen zu halten, wenn sich der Kolben 26 in der ausgefahrenen Endstellung befindet. Des Weiteren ist zwischen der Innenseite des Gehäuses 10 und der Außenseite der Kolbenstange 22 ein radialer Abstand geschaffen, der einen hohlzylindrischen Fluid- oder Stangenraum 50 ausbildet mit veränderbarem Volumen. Die Kolbenstange 22 ist im Anschlussbereich zum Kolben- oder Führungsteil 26 mit einer ringförmigen Innendichtung 52 versehen; ebenso ist eine stationäre ringförmige Außendichtung 54 zwischen der Außenseite des weiteren Führungsteiles 36 und der Innenumfangsseite des Gehäuses 10 in Richtung des Stangenraumes 50 vorhanden.

In der gezeigten Stellung nach der Figur 1 ist das Kolben- oder Führungsteil 26 von unten her über den Fluid- oder Stangenraum 50 mit Fluid, insbesondere Hydrauliköl, vorggebbaren Druckes beaufschlagt, welches über die kanalartige Durchlassstelle 46 in den Raum 50 eingebracht ist. Wird der dahingehende Druck an der Durchlassstelle 46 respektive dem Eingang in den Fluid- oder Stangenraum 50 weggenommen und Druck über den Fluidkanal 18 auf die Oberseite des Kolben- oder Führungsteiles 26 aufgebracht, bewegt sich in Blickrichtung auf die Figur 1 gesehen die Kolben-Stangeneinheit 34 von oben nach unten und fährt insoweit um eine vorgebbare Wegstrecke aus dem Zylindergehäuse 10 aus. Die dahingehend freie Verfahrstrecke ist jedenfalls insoweit begrenzt als das eine Kolben- oder Führungsteil 26 in stirnseitige Anlage kommt mit dem unteren oder weiteren stationären Führungsteil 36. Für das Einfahren der Kolben-Stangeneinheit 34 ist dann der Druckverlauf wiederum umzukehren und der gewinkelte Fluidkanal 18 drucklos zu machen. Je nach herrschenden Druckverhältnissen kann die Kolben-Stangeneinheit 34 aber auch Zwischenstellungen innerhalb des Zylindergehäuses 10 einnehmen, was einem üblichen Betrieb entspricht. Insbesondere lässt sich dergestalt der Arbeitszylinder als Ganzes in eine vorgebbare Ausfahrposition bringen, um dergestalt Fahrzeugplattformen auf einem Boden oder dergleichen aufständern und abstützen zu können.

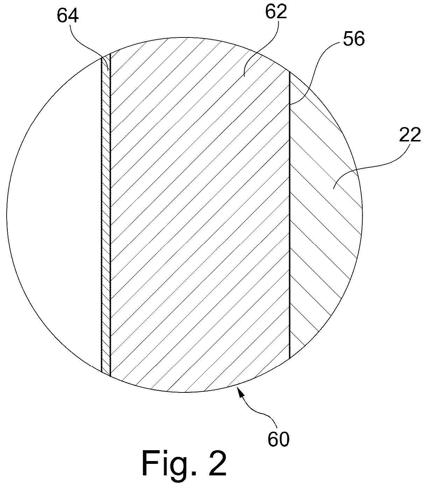

Die Kolbenstange 22 besteht bevorzugt aus einem Kohlenstoffstahl, wie beispielsweise 42CrMo4. Insoweit weist die Kolbenstange 22 zumindest auf ihrer Oberseite 56 einen dahingehenden Stahlwerkstoff auf, wobei die dahingehende Oberseite 56 respektive die dahingehende Oberfläche außerhalb der Verbindung mit dem Kolben- oder Führungsteil 26 durchgehend bis zu einem oberen Endbereich 58 an der Übergangsstelle zum kugelförmigen Abschlussteil 44 mit einer Beschichtung 60 versehen ist, was im Folgenden, insbesondere anhand der Figur 2 noch näher erläutert werden wird.

Die Beschichtung 60 gemäß dem Bildausschnitt nach der Figur 2 ist auf der Oberseite 56 respektive auf der Außenumfangsseite der Kolbenstange 22 im vorstehend genannten Flächenbereich aufgebracht. Wie bereits ausgeführt, ist die Kolbenstange 22 durchgehend aus einem Stahlwerkstoff gebildet, vorzugsweise in Form von Kohlenstoffstahl, besonders bevorzugt in der Ausgestaltung von 42CrMo4. Hierbei handelt es sich um einen CrMo-legierten Vergütungsstahl mit einer Festigkeit, regelmäßig von 900 bis 1200 N/mm².

Die dahingehende Oberseite 56 der Kolbenstange 22 ist mit einer Lage 62 überzogen, die wiederum von einer zuäußerst angeordneten Lage 64 umgeben ist, die keramikfrei und glanzlos, vorzugsweise schwarz, ausgebildet ist. Bei einer bevorzugten Ausführungsform der erfindungsgemäßen Beschichtung besteht die Lage 62 aus Nickel, welches in der vorliegenden kompakten Form im Rahmen üblicher Betriebstemperaturen eines Arbeitszylinders gegen Luft, Wasser, Salzsäure und Laugen sehr beständig und nicht brennbar ist. Insoweit ist Nickel respektive die Lage 62 als chemikalienbeständig anzusehen.

Bevorzugt wird der jeweilige Nickelwerkstoff galvanisch abgeschieden, wofür ein äußerer elektrischer Strom anzulegen ist. Die Schichtdicke für die Nickellage 62 ist vorzugsweise zwischen 50 *µ*m bis 150 *µ*m gewählt und ist jedenfalls deutlich dicker oder mächtiger ausgebildet als die zuäußerst angeordnete dünne Lage 64. Des Weiteren ist die Lage 62 gemäß der Darstellung nach der Figur 2 als eine einzelne Schicht aufgezeigt; es besteht aber hier durchaus die Möglichkeit in einem mehrlagigen Schichtaufbau die Nickellage 62 mit unterschiedlichen nickelhaltigen Beschichtungswerkstoffen zu erzeugen, was insbesondere für den Erhalt einer entsprechend großen Schichtdicke für die Lage 62 ggf. vonnöten ist. Der jeweilige galvanische Nickelüberzug für technische Zwecke erfolgt anhand der deutschen Norm DIN EN ISO 4526 aus September 2004 (EN ISO 4526:2004).

Die bereits angesprochene und zuäußerst angeordnete Lage 64 ist keramikfrei und glanzlos, vorzugsweise schwarz, ausgebildet. Die dahingehende Lage 64 ist mehrschichtig, insbesondere dreischichtig, aufgebaut, und ist der Einfachheit halber in der Figur 2 jedoch nur als Einschichtlage wiedergegeben. Die Lage 64 besteht bevorzugt aus amorphem Kohlenstoff, der fachsprachlich auch mit Diamond-like Carbon (DLC) bezeichnet ist. Es handelt sich hierbei um jeweils sehr harte, aber zugleich auch reibungsarme Schichten, die zudem chemisch beständig sind. Dahingehende Lagen oder Schichten aus amorphem Kohlenstoff werden mittels eines physikalischen Gasphasenabscheideverfahrens (PVD) auf die Nickellage 62 aufgebracht.

Bei der bevorzugt im PVD-Verfahren aufgebrachten DLC-Beschichtung handelt es sich um ein Kohlenstoffschichtsystem nach der deutschen Norm DIN 4855 aus September 2015. Im einzelnen handelt es sich dabei um ein Schichtsystem nach DIN 4855-1.7225; bestehend aus einer innenliegenden 0,5 *µ*m dicken Cr-Haftschicht, einer 1 *µ*m dicken CrN-Zwischenschicht und einer 3*µ*m dicken außenliegenden Funktionsschicht in Form einer homogenen, einphasigen, wasserstoffhaltigen, amorphen Kohlenstoffschicht.

Die derart erhaltene schwarze Beschichtung 64 weist einen ausgesprochen geringen Reibwert von 0,1 bei einer sehr großen Härte von 3400 HV auf. Insbesondere ist das Schichtmaterial für die zuäußerst angeordnete Lage 64, wie bereits dargelegt, aus einer wasserstoffhaltigen, amorphen Kohlenstoffschicht a-C:H mit einem H-Anteil > 35% erhalten. Jedenfalls kann die zuäußerst angeordnete Lage 64, ohne ihre Funktion einzubüßen, sehr dünn ausgebildet sein, beispielsweise mit einer Lagen- oder Schichtdicke zwischen 1 *µ* bis 5 *µ*m.

Unter Beibehalten der zuäußerst angeordneten Lage 64 als amorpher Kohlenstoffschicht, wie vorstehend dargelegt, kann die darunter liegende Lage 62 auch aus einem anderen Nickel beinhaltenden Werkstoff gebildet sein. In Frage kommen hier chemikalienbeständige Lagen 62 aus:
- Nickel/Chrom (Ni/Cr),
- Chromcarbid (CrC/NiCr),
- Chromcarbid-Wolframcarbid (CrC/WC/NiCr) oder
- Nickel/Chrom/Silizium (Ni/Cr/Si),

die bevorzugt jeweils mittels Hochgeschwindigkeitsflammspritzen (HVOF) auf das Substrat in Form der Kolbenstange 22 aufgebracht werden. Beim sogenannten Hochgeschwindigkeitsflammspritzen (High-Velocity-Oxygen-Fuel) ist ein thermisches Beschichtungsverfahren zur Oberflächenbearbeitung angesprochen, bei dem Spritzpartikel, sprich die genannten Beschichtungswerkstoffe, auf sehr hohe Geschwindigkeiten beschleunigt werden, so dass sich hieraus resultierend sehr dichte Spritzschichten mit hervorragenden Hafteigenschaften ergeben. Dabei wird durch die regelbare und für den Auftrag gerade ausreichende Wärmeeinbringung der aufzuspringende Spritzwerkstoff durch den eigentlichen Spritzprozess nur gering metallurgisch verändert, was dem Materialverhalten in Verbindung mit der Oberseite 56 des Stangenteils 24 zugutekommt.

Alternativ kann die Lage 62 auch aus Nickel/Molybdän (Ni/Mo) aufgebaut sein, welches mittels LaserCladding-Technik aufgetragen wird. Hierbei handelt es sich um ein Laserauftragsschweißverfahren, wobei ein Laserstrahl auf einer Werkstückoberfläche, hier auf der Oberseite 56 der Kolbenstange 22, ein Schmelzbad generiert, dem zugleich das Beschichtungsmaterial Nickel/Molybdän, vorzugsweise in Pulverform, zugeführt und vom Laser mit aufgeschmolzen wird. Ergebnis ist eine Lage 62, die metallurgisch mit dem Grundmaterial der Kolbenstange 22 intrinsisch fest verbunden ist. Diese erweist sich regelmäßig deutlich strapazierfähiger gegenüber Beschichtungen, die durch thermisches Spritzen erzeugt werden, und ist in jedem Fall gesundheitlich unbedenklich.

Alternativ kann eine aus Nickel/Chrom/Silizium (Ni/Cr/Si) bestehende Lage 62 anstelle des Auftrags mittels Hochgeschwindigkeitsflammspritzen auch mittels einer Schmelzverbund-Technik aufgebracht werden. Dem Grunde nach handelt es sich hierbei gleichfalls um eine Art Einschmelzverfahren, bei dem mittels Acetylen-Sauerstoff-Brennen der Beschichtungswerkstoff auf die Kolbenstange 22 aufgebracht wird. Nach dem Auftragen des Beschichtungswerkstoffes wird er mittels einer Induktionsspule in das zu beschichtende Bauteil quasi mit eingeschmolzen.

Handelt es sich bei der Beschichtung 62 im Wesentlichen ausschließlich um den Grundwerkstoff Nickel, kann die Lage 62 auch als sogenannte Chemisch-Nickel-Beschichtung konzipiert sein, wobei dahingehend Nickel durch eine Redox-Reaktion auf der Stahl- Kolbenstange 22 mit ihrer katalytisch aktiven Oberfläche respektive Oberseite 65 abgeschieden wird.

Unabhängig davon welche Beschichtungslagen 62 und 64 tatsächlich eingesetzt werden, werden diese jedenfalls im Rahmen einer besseren Anhaftung mit der darunterliegenden Kolbenstange 22 endseitig mit einer Übergangsschräge 66 (Figur 1) versehen, was gleichfalls eine verbesserte Anhaftung mit der darunter angeordneten Oberseite 56 der Kolbenstange 22 ergibt. Vorzugsweise kann die Übergangsschräge 66 in einem flachen Winkel von beispielsweise 20° in die Oberseite 56 der Kolbenstange 22 übergehen; andere konische Winkelgestaltungen sind hier möglich. Die jeweilige Übergangsschräge 66 ist auch notwendig, um die Dichtungen nicht zu beschädigen, wenn die Kolbenstange 22 in dem Deckel 38 einmontiert wird. Die Schräge 66 hat dabei einen Winkel zwischen 10° und 30°, vorzugsweise von 15°.

Zum Herstellen einer Kolbenstange 22 mit der jeweiligen Beschichtung 62 und 64 dient das nachfolgende Herstellverfahren mit Herstellschritten in der genannten Reihenfolge:
1. Rohmaterial der Kolbenstange 22 vordrehen auf Maß (Fertigdurchmesser + 0,1 mm)
2. Vorgedrehte Kolbenstange 22 auf Maß schleifen (Fertigdurchmesser-Gesamtschichtdicke)
3. Nickelbeschichtung 62: Galvanischer Überzug nach ISO 4526-Fe/Ni100sf, Schichtstärke 100 *µ*m (- 0/ + 20*µ*m)
4. Schleifen auf Maß (Fertigdurchmesser - DLC-Schichtdicke)
5. DLC-Beschichtung 64 im PDV-Verfahren: Kohlenstoffschichtsystem nach DIN 4855-1.7225.

Insgesamt lässt sich mit der erfindungsgemäßen Lösung ein Arbeits- oder Hydraulikzylinder herstellen mit einer Kolbenstange 22, die auf ihrer Oberseite 56 eine Schichtkombination 62, 64 aus Ni und DLC aufweist. Diese ist beständig gegen eine salzsäurehaltige Atmosphäre und dank der erzeugten, nicht glänzenden Oberfläche der Kolbenstange 22 ist diese besonders für Militäranwendungen geeignet. Dies hat so keine Entsprechung im Stand der Technik.

## Patentansprüche

1. Kolbenstange (22) für einen hydraulischen Arbeitszylinder (8), die zumindest auf ihrer Oberseite (56) einen Stahlwerkstoff aufweist, der zumindest teilweise mit einer Lage (62) überzogen ist, die Nickel oder Nickelbestandteile in Form eines galvanisch aufgebrachten Überzugs aufweist, der als weitere Lage (64) darüberliegend zumindest teilweise eine DLC-Beschichtung aufweist, die mittels eines physikalischen Gasphasenabscheideverfahrens aufgebracht ist.

2. Kolbenstange nach Anspruch 1, **dadurch gekennzeichnet, dass** die DLC-Beschichtung gleichfalls Nickel beinhaltet.

3. Kolbenstange nach Anspruch 1 oder 2, **dadurch gekennzeichnet, dass** die eine Lage (62) zumindest aus einer der folgenden Materialien besteht:
- Nickel (Ni),
- Nickel/Molybdän (Ni/Mo),
- Nickel/Chrom (Ni/Cr),
- Chromcarbid (CrC/NiCr),
- Chromcarbid-Wolframcarbid (CrC/WC/NiCr) oder
- Nickel/Chrom/Silizium (Ni/Cr/Si).

4. Kolbenstange nach einem der vorstehenden Ansprüche, **dadurch gekennzeichnet, dass** die DLC-Beschichtung als der weiteren Lage (64), ausgehend von der einen Lage (62), in Hintereinanderanordnung folgenden Aufbau hat:
- eine Haftschicht aus Chrom,
- eine Zwischenschicht aus Chrom/Nickel, und
- eine Funktionsschicht in der Art a-C:H

5. Kolbenstange nach einem der vorstehenden Ansprüche, **dadurch gekennzeichnet, dass** die weitere Lage (64) als Funktionsschicht derart amorphen Kohlenstoff aufweist, dass die Kolbenstange schwarz gefärbt und glanzlos ist.

6. Kolbenstange nach einem der vorstehenden Ansprüche, **dadurch gekennzeichnet, dass** die eine Lage (62) eine Schichtdicke zwischen 15 *µ*m bis 500 *µ*m, vorzugsweise zwischen 25 *µ*m bis 150 *µ*m, und die jeweils weitere Lage (64) eine Schichtdicke zwischen 1 *µ*m bis 5 *µ*m, besonders bevorzugt zwischen 2 *µ*m bis 4 *µ*m, aufweist.

7. Kolbenstange nach einem der vorstehenden Ansprüche, **dadurch gekennzeichnet, dass** der Stangenwerkstoff aus einem Kohlenstoffstahl besteht, wie 42CrMo4.

8. Kolbenstange nach einem der vorstehenden Ansprüche, **dadurch gekennzeichnet, dass** die jeweilige Lage (62, 64) in Richtung der einander gegenüberliegenden Enden der Kolbenstange (22) mit jeweils einer Schräge (66) versehen ist, die in Richtung des benachbart angeordneten Kolbenstangenendes konisch zuläuft.

9. Verfahren zum Herstellen einer Kolbenstange (22) nach einem der vorstehenden Ansprüche, **gekennzeichnet durch** die folgende Herstellabfolge:
- Vordrehen der Kolbenstange (22) auf Maß,
- Vorgedrehte Kolbenstange (22) auf Maß schleifen,
- Aufbringen einer Nickelbeschichtung als der einen Lage (62),
- Erneutes Schleifen auf Maß,
- Aufbringen einer DLC-Beschichtung im PVD-Verfahren als der weiteren Lage (64).

10. Verwendung eines Arbeitszylinders für militärische Zwecke, dessen Kolbenstange (22) nach den Patentansprüchen 1 bis 8 aufgebaut und bevorzugt mit einem Verfahren nach Anspruch 9 hergestellt ist, die aufgrund ihres glanzlosen, schwarzen Aussehens eine Tarnfunktion, insbesondere bei Militärfahrzeugen mit hydraulisch betätigbaren Komponenten, erfüllt.
